# EUROPEAN PATENT APPLICATION

(11) **EP 0 549 186 A1**
(43) Date of publication of application: **30.06.1993**
(21) Application number: 92311195.9
(22) Date of filing: 09.12.1992
(51) Int. Cl.: C23C 16/26

(54) **Diamond films**

(30) Priority: 26.12.1991 US 813622
(71) Applicant: GENERAL ELECTRIC COMPANY, Schenectady, NY 12345 (US)
(72) Inventor: Savkar, Sudhir Dattatraya, Schenectady, New York 12309 (US)
(74) Representative: Pratt, Richard Wilson

(57) **Abstract**

This invention relates to an apparatus and method for making large area diamond films using a high temperature plasma reactor with a plasma reactor stream flow controller employing an electro-arc technique and constructed of a refractory material such as graphite or tungsten. Such structures of this type generally allow large area diamond films to be created on a substrate in an efficient, cost-effective manner.

## Description

### Cross Reference to Related Applications

This application is related to commonly assigned U.S. Patent Application Serial No. 07/813621 (RD-21,857), 07/813620 (RD-21,404), 07/813618 (RD-21,502), and 07/813619 (RD-21,407) entitled "Apparatus and Method for Controlling the Formation of Diamond Films and Patterns Using Non-Carbonaceous Refractory Materials"; "Apparatus and Method for Making Large Area Diamond Films Using Carbonaceous Refactory Materials"; "Apparatus and Method for Making large Area Diamond Films Using Non-Carbonaceous Refractory Materials"; ad "Apparatus and Method for Controlling the Formation of large Area Diamond Films ad Diamond Film Patterns".

### Background of the Invention

### Field of the Invention

This invention relates to a apparatus ad method for making large area diamond films using a high temperature plasma reactor with plasma reactor stream flow controller employing a electro-arc technique ad constructed of a refractory material such as tungsten or graphite where hydrocarbon injection may be used. Such structures of this type, generally, allow large area diamond films to he created on a substrate in an efficient, cost-effective manner.

### Description of the Related Art

It is known that the local temperature of the plasma of a high temperature plasma gun such as a DC torch or a radio frequency (RF) torch can reach as high as 8000^{.}K ad can be accurately measured by bare ad sheathed tungsten/rhenium thermocouples. This technique was set forth by S.D. Savkar and R.S. Miller in a article entitled "RF Plasma Torch Temperature Field Measurements Using Thermocouples", 9th International Symposium on Plasma Chemistry, September, 1989. In this technique, thermocouples of tungsten/rhenium were formed into a rake and the rake was deployed within the plasma gun plume. Typically, tungsten melts at approximately 3500-3600^{.}K. However, when the rake was placed in the plasma gun plume, the thermocouples did not melt. Basically, this is because tungsten is a refractory material and a good thermal radiator thus, the thermocouples exhibited a excellent balance between thermal radiation and thermal absorption. In short, the tungsten thermocouple in this case was able to rapidly cool itself as it was deployed in the gun plume. This cooling effect of the tungsten thermocouple allowed accurate measurements of the local temperature of the plasma to be performed, which, in turn, allowed the temperature of the gun plasma to be more accurately controlled. However, a more advantageous system, then, would be presented if other refractory materials which exhibit good thermal radiation techniques could be employed.

Presently, in the formation of diamond films, a DC torch is employed that has a diffuser attached. While this technique creates diamond films, these films do not achieve the desired size in surface area coverage. This is because, typically, the diffuser is constructed of copper ad is water cooled. The diffuser must be constantly cooled in order to keep the diffuser from destructing due to the high temperatures of the plasma stream and this cooling adversely affects the deposition characteristics of the stream. Also, the stream must be recirculated within the diffuser in order to spread the stream flow out to create a diamond film. The spreading of the flow should create a large diamond film, but, typically, the recirculation of the flow traps the flow and a large area diamond film is not created. Finally, although the use of several diffusers placed side-by-side has been employed, a uniform large area diamond film was still difficult to achieve because the spacing between the diffusers created inconsistencies in the film thickness ad a inordinate amount of skill by the artisan was required to attempt to alleviate this problem. Therefore, a still further advantageous system would be presented if refractory materials having good thermal radiation properties could be used which did not adversely affect the flow of the plasma stream but still created a large area diamond film. A second feature of the DC arc plasma guns, commonly used for making diamonds using high temperature or thermal plasmas, is the need of excessive amount of fuel gases used to rotate the point of arc attachment at the anode, the so called anode footprint This is done to avoid melting or burning up the anode structure. This use of a large amount of fuel gas impacts adversely on the economics of the diamond product.

It is apparent from the above that there exists a need in the art for a system which is capable of withstanding the high temperatures of a typical plasma stream, and which does not adversely affect the flow of the plasma stream, but which at the same times is capable of producing uniform, large area diamond films and do this with reduced consumption of gases such as argon and hydrogen. It is a purpose of this invention to fulfill these and other needs in the art in a manner more apparent to the skilled artisan once given the following disclosure.

### Summary of the Invention

Generally speaking this invention fulfills these needs by providing a apparatus for producing large area diamond films on a substrate, comprising a plasma gun means having a plasma stream, and an arc formation means substantially constructed of a refractory material having high thermal radiation properties and substantially located between said gun means and said substrate.

In certain preferred embodiments, the plasma gun means are a DC torch or an RE torch. Also, the arc formation means is a cathode/anode structure or electrode constructed of graphite, tungsten or copper, as per specific gun design objectives. Finally, methane may be used depending upon the type of refactory material used.

In another further preferred embodiment, the arc formation means creates a secondary flow of plasma flow material while spreading out the flow of diamond material Such that a diamond film is formed over a relatively large area of a substrate.

The preferred system, according to this invention, offers the following advantages: smaller size, easy assembly; good economy; easy formation of larger area diamond films; good stability; excellent durability; and high strength for safety. In fact, in many of the preferred embodiments, these factors of ease of diamond film formation ad durability are optimized to a extent considerably higher than heretofore achieved in prior, known diamond film formation systems

### Brief Description of the Drawings

The above and other features of the present invention which will become more apparent as the description proceeds are best understood by considering the following detailed description in conjunction with the accompanying drawings wherein like characters represent like parts throughout the several views and in which:
Figure 1 is a graphical representation where a graphite rod monitors RF plasma temperatures and temperature (^{.}K) is plotted against radial distance (mm) from the jet centerline;
Figure 2 is a schematic drawing of a DC arc reactor with an electrode and and a nozzle, according to the present invention;
Figure 3a is a schematic drawing of an arc reactor with an electrode and rotating current pulses according to the present invention; and
Figure 3b is a graphical representation of the current pulses for the reactor the Figure 3a, with current (A) plotted against time (sec.).

### Detailed Description of the Invention

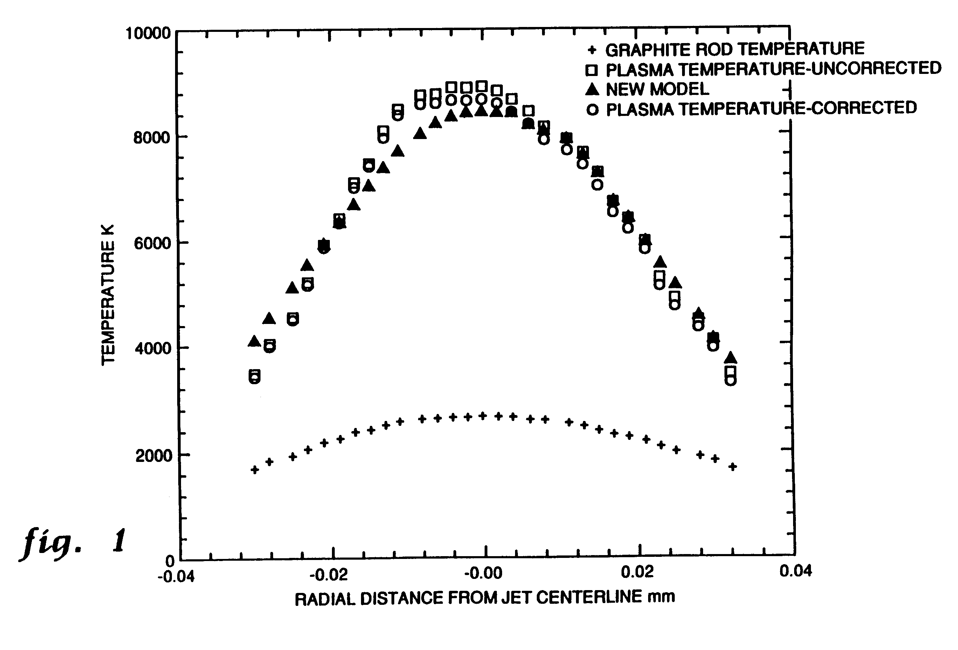

In order to more fully understand the nature of the process which is utilized to create large area diamond films, a brief background is presented. Carbon (C) and hydrogen (H₂) have a strong affinity over a wide range of temperatures and their chemistry plays a important role in the formation of diamond in the plasma jet or hot filament process. At the elevated plasma temperatures typically, around 8000^{.}K, the hydrogen in the plasma reacts with graphite to strip off the carbon from the graphite, forming a variety of components such as CH, CH₂, CH₄, etc. These components then decompose, forming the diamond film on the suitably located ad cooled substrate. Measurements show that the graphite structure can basically survive in these plasmas so long as there is sufficient cooling for it, in the form of radiant sinks or internal (gas helium or even liquid water) cooling. The plasmas radiate relatively weakly in the mid-to-long wavelength infrared, permitting an unobstructed measurement of the infrared radiance of the graphite. Such measurements can be used to monitor the reaction and the quality of the product made. A sample set of temperature measurements for a 3.17 mm graphite rod inserted at a point 47.6 mm just below a RF torch operating with a mixture of 1/3 argon and 2/3 helium, at 250 torr, with torch (plate) power setting of about 67 KW are illustrated in Figure 1. The rod effectively cooled itself by radiation to the water cooled walls of the tank held at about 350° K. The underlying theory for this phenomena is the effective survivability of the graphite structure, suitably designed and suitably located in a plasma, provided the graphite has a low temperature sink it can radiate to. Plasma temperatures as high as 10000^{.}K have been monitored in this way. It is to be understood that a refractory metal structure, such as a tungsten structure would perform in much the same manner but a hydrocarbon, such as the commonly used methane gas, must be added in order to form diamond. In the latter case the presence of the refractory metal, especially tungsten, appears to aid in the process of forming atomic hydrogen from molecular hydrogen.

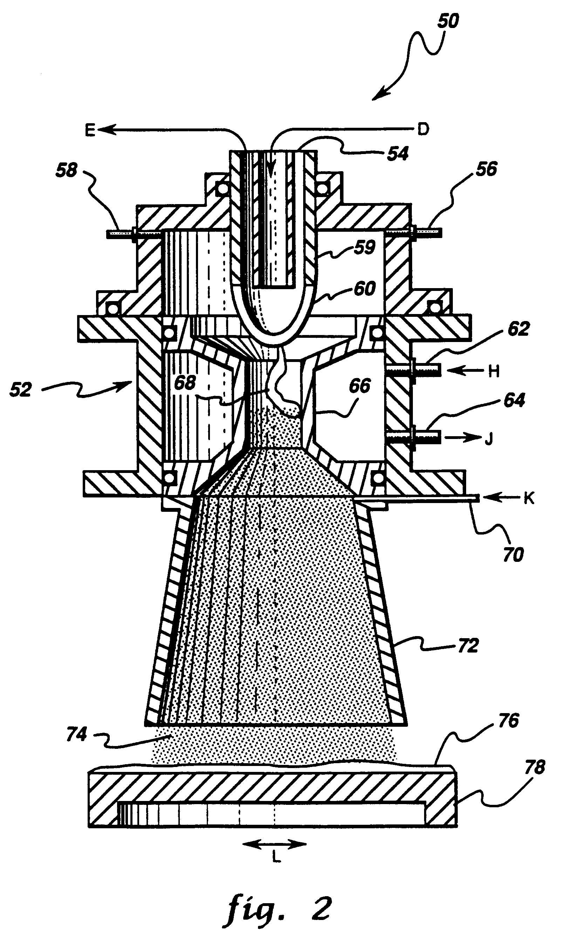

With respect to Figure 2, apparatus 50 for producing large area diamond film 76 on substrate 78 is illustrated. In particular, apparatus 50 includes, in part, DC arc reactor 52. It is to be understood that while a DC arc reactor 52 is utilized in apparatus 40, other plasma torches can be used Reactor 52 includes inlet 54, preferably, for allowing cooling water to flow into reactor 52 along the direction of arrow D and out of reactor 52 along the direction of arrow E. Located below inlet 54 are inlets ports 56,58. Port 56, preferably, introduces argon gas into reactor 52 and port 58 introduces hydrogen gas into reactor 52. Body 59, preferably, is constructed of copper.

Located within reactor 52 is cathode 60. Cathode 60, preferably, is attached to body 59 by conventional attachment means and is constructed of a refractory material, such as tungsten, (although in certain applications a refractory material, such as graphite, may be used). Ports 62 and 64 are located so as to provide cooling water into and out of the region formed between the anode 66 and reactor 52, respectively. Anode 66 which, preferably, is constructed of copper (although in certain applications graphite may be used) is located below cathode 60 such that as reactor 52 is operated, a rotating arc 68 is created between cathode 60 and anode 66. When graphite is used in cathode 60 or anode 66, arc 68 causes the cathode 60 and the anode 66 to deteriorate as diamond film 76 is formed. Thus, cathode 60 and anode 66, which now becomes either the primary or secondary source of carbon to form diamonds, should be periodically replaced the period being shorter than if cathode 60 was constructed of tungsten and anode 66 was constructed of copper. It is understood that while cathode 60 and anode 66 are described as being constructed of graphite or tungsten, cathode 60 or anode 66 may be the only structures constructed of graphite or tungsten in order, for example, to deposit diamond film 76 at a slower rate. However, a graphite cathode 60 should not be used with a tungsten anode 66, although a conventional tungsten cathode may be used with a graphite anode.

Located below anode 66 is inlet port 70. Port 70 may be utilized to inject a hydrocarbon, such as methane, into arc stream 74 along the direction of arrow K in order, for example, to increase the deposition rate of film 76. Port 70 can be located at other points in apparatus 50 provided the plasma temperature there is sufficiently high. Nozzle 72 is located below port 70. Nozzle 72, preferably, is constructed of graphite. It is to be understood that if cathode 60 is constructed of tungsten, anode 66 is constructed of copper and nozzle 72 is constructed of tungsten, then methane must be injected into reactor 52. Nozzle 72 may also assist in the formation of film 76 when arc stream 74 contacts nozzle 72 and carbon molecules form nozzle 72 made of graphite are released into stream 72 ad are deposited on substrate 78 to form film 76. Substrate 8, preferably, is constructed of silicon or molybdenum Substrate 78 is rigidly attached to a conventional oscillator which causes substrate 78 to move in the direction of arrow L. In this manner, as substrate 78 is oscillated, film 76 is deposited over a larger area of substrate 78 to create a large area diamond film 76. It is to be understood that several reactors apparatus 50 can be placed in a side-by-side relationship in order to create even larger diamond films. In this way, substrate 78 may not need to be oscillated. It is to be understood that a reversed transferred arc (not shown) between electrode 60 and nozzle 72 can be employed to enhance the stripping of carbon from nozzle 72 and, in turn, the formation of diamond film 76.

The proper selection of the substrate and its temperature is very important. The selection of the substrate temperature is a function of a number of parameters, including the amount of stresses built up in film 76. In general, a substrate temperature in excess of 700^{.}K is preferred. The substrate temperature determines the amount of hydrogen left in film 76, in that, the higher the substrate temperature, the lower the retained hydrogen in the film. It is possible that the temperature may have to be as high as 1200-1300^{.}K, especially if hydrogen free films are desired. There is clearly an upper bound to this temperature, because beyond a certain point, the graphitization of the deposited film is favored, not to mention the difficulty of operating with most substrate materials at such high temperatures.

It is to be understood that graphite is not necessary, rather any carbon based structure which has sufficient integrity to withstand the rigors of the environment for sufficiently long period will do. It follows, therefore, that the subject structure (the anode, cathode or nozzle as appropriate) will have to be periodically replaced as the carbon from the structure gets deposited into film 76. The amount of hydrogen, especially atomic hydrogen, is thought to play a important role in forming diamond film 76. Indeed, the presence of atomic hydrogen impedes the formation of graphite under rapid quenching. The high temperatures of the thermal plasma insures that molecular hydrogen will be dissociated into atomic hydrogen over bulk of the plasma plume.

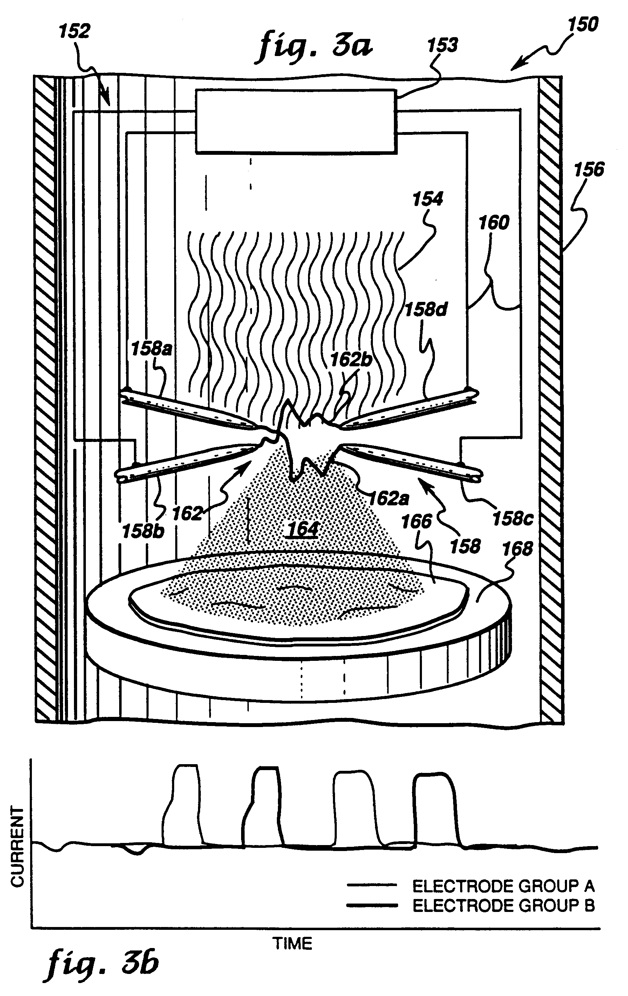

With respect to Figure 3a, apparatus 150 for controlling the formation of large area diamond film 166 on substrate 168 with reduced flow of argon/hydrogen fuel gas is illustrated. In particular, apparatus 150 includes, in part, arc reactor 152 which is located within reactor vessel 156. Reactor 152, preferably, is constructed of a conventional power source 153, plasma stream 154, arc electrodes 158, conventional electrical leads 160 and arcs 162. Power source 153 is a conventional steady base ad pulsating current power supply which must be capable of providing a base level of current between electrode 158 and a rapid current spike between a electrode 158, which effectively causes arc 162 to rotate. Plasma stream 154 is created in a conventional manner. Electrodes 58, preferably, are constructed of carbonaceous material such as carbon or graphite.

Located between electrodes 158 are arcs 162. Arcs 162, preferably, are formed in an alternating manner as illustrated in Figure 2b. In particular, an arc 162 is struck between electrodes 158a and 158c by power source 153 then, an arc 162b is struck between electrodes 158b and 158d by power source 153. Arcs 162 react with plasma stream 154 and electrodes 158 to create secondary flow 164. Flow 164 is deposited on substrate 168 to form large area diamond film 166. Substrate 168, preferably, is constructed of the same material as substrate 78 (Figure 2).

Once given the above disclosure, many other features, modifications and improvements will become apparent to the skilled artisan. Such features, modifications and improvements are, therefore, considered to be a part of this invention, the scope of which is to be determined by the following claims.

## Claims

1. An apparatus for producing large area diamond films on a substrate, said apparatus comprised of:
a plasma gun means having a plasma stream; and
an arc formation means substantially constructed of a refractory material having high thermal radiation properties and substantially located between said gun means and said substrate.

2. The apparatus, according to Claim 1, wherein said substrate is further comprised of:
silicon or molybdenum.

3. The apparatus according to Claim 1 or Claim 2, wherein said arc formation means is further comprised of:
graphite, tungsten or a refractory metal.

4. The apparatus according to any preceding claim, wherein said arc formation means is further comprised of:
a plasma torch means or a DC arc reactor.

5. The apparatus, according to Claim 4, wherein said DC arc reactor is further comprised of:
a graphite cathode, a graphite anode, a tungsten cathode or a copper anode.

6. The apparatus, according to any preceding claim, wherein said apparatus is further comprised of:
an oscillating means for oscillating said substrate.

7. The apparatus, according to any preceding claim, wherein said arc means is constructed of:
electrodes.

8. The apparatus, according to any preceding claim, wherein said arc formation means is further comprised of:
a steady base and pulsating current power supply.

9. A method for controlling the production of large area diamond films on a substrate having a plasma gun means emitting a plasma stream, an arc formation means constructed of a refractory material having high thermal radiation properties, wherein said method is comprised of the steps of:
activating said plasma gun means to create said plasma stream;
locating said flow control means within said plasma stream;
creating an arc in said arc formation means;
impinging said plasma stream on said arc;
increasing a surface area coverage of said plasma stream; and
depositing a diamond film on said substrate to create a large area diamond film.

10. The method, according to Claim 9, wherein said step of creating an arc in said arc formation means is further comprised of the step of:
inducing a current through said arc formation means.

11. The method, according to Claim 10, wherein said step of inducing said current through said arc formation means is further comprised of the step of:
creating a rotating arc between said flow control means.
